# EUROPEAN PATENT APPLICATION

(11) **EP 4 704 544 A1**
(43) Date of publication of application: **04.03.2026**
(21) Application number: 25198259.1
(22) Date of filing: 26.08.2025
(51) Int. Cl.: H10W 76/12, H10W 76/60, H10W 72/00

(54) **LAMINATE PACKAGE LID TO PREVENT DELAMINATION**

(30) Priority: 29.08.2024 US 202463688372 P; 12.08.2025 US 202519297436
(71) Applicant: STMicroelectronics International N.V., 1228 Plan-les-Ouates, Geneva (CH)
(72) Inventor: LOH, Hung Meng, 670118 Bukit Panjang (SG)
(74) Representative: Casalonga

(57) **Abstract**

An example laminate package, a method for manufacturing the laminate package, and an electrical system comprising the laminate package configured to prevent delamination of the thermal interface material is provided. The example laminate package includes a semiconductor IC (102) electrically connected to a substrate (104) in a flip-chip ball grid array configuration (106) a substrate, and a laminate package lid (108). The laminate package lid includes a top portion (108a), an outer wall (108b), and a protruding member (330). The top portion covering the semiconductor IC, wherein the top portion of the laminate package lid is in thermal contact with the semiconductor IC. The outer wall perpendicular to the top portion, wherein the outer wall is attached to an outer portion of the substrate by a first adhesive substance (112). The protruding member extending from the top portion and attaching to the substrate between the semiconductor IC and the outer wall by a non-conductive adhesive substance (550).

## Description

### TECHNOLOGICAL FIELD

Embodiments of the present disclosure relate generally to laminate packages, and more particularly, to a laminate package lid designed to prevent delamination of thermal interface material.

### BACKGROUND

Many electronic systems utilize printed circuit boards (PCBs) to support and connect the various electrical components of the electrical system. For example, a PCB may include a rigid structure with a plurality of mount regions configured to receive various electrical components. The PCB may further include conductive traces or paths to enable electrical connections between the various electrical components. A PCB may commonly receive surface-mounted and/or socketed electrical components, including various integrated circuits (ICs), packaged in a protective housing, such as laminate packages.

Applicant has identified many technical challenges and difficulties associated with the reliability of laminate packages. Through applied effort, ingenuity, and innovation, Applicant has solved problems related to the reliability of laminate packages by developing solutions embodied in the present disclosure, which are described in detail below.

### BRIEF SUMMARY

Various embodiments are directed to an example laminate package, a method for manufacturing the laminate package, and an electrical system comprising the laminate package configured to prevent delamination of the thermal interface material. An example laminate package is provided. The example laminate package comprises a semiconductor IC, a substrate, and a laminate package lid. The semiconductor IC electrically connected to the substrate in a flip-chip ball grid array configuration. The laminate package lid comprising a top portion, an outer wall, and a protruding member. The top portion covering the semiconductor IC, wherein the top portion of the laminate package lid is in thermal contact with the semiconductor IC. The outer wall perpendicular to the top portion, wherein the outer wall is attached to an outer portion of the substrate by a first adhesive substance. The protruding member extending from the top portion and attaching to the substrate between the semiconductor IC and the outer wall by a non-conductive adhesive substance.

In some embodiments, a cross-section of the protruding member at an interface with the substrate comprises at least one dimension greater than one millimeter.

In some embodiments, the cross-section of the protruding member at the interface with the substrate is a rectangle having a first dimension and a second dimension.

In some embodiments, the protruding member further comprising a protruding member height measured from a bottom surface of the top portion of the laminate package lid, wherein the protruding member height is between 0.2 millimeters and 0.3 millimeters.

In some embodiments, a first distance between the protruding member and the semiconductor IC is less than a second distance between the protruding member and the outer wall.

In some embodiments, the first distance is between 1 millimeter and 2 millimeters.

In some embodiments, the laminate package lid further comprising a second protruding member positioned opposite the semiconductor IC from the protruding member.

In some embodiments, the laminate package lid further comprising a plurality of protruding members, wherein each protruding member of the plurality of protruding members is positioned on a different side of the semiconductor IC.

In some embodiments, the first adhesive substance and the non-conductive adhesive substance comprise the same substance.

In some embodiments, the laminate package further comprising thermal interface materials positioned between the laminate package lid and the semiconductor IC.

In some embodiments, the thermal interface materials provide a thermally conductive path between the semiconductor IC and the laminate package lid.

In some embodiments, the laminate package lid comprises a metal material.

A method of manufacturing a laminate package is further provided. The method of manufacturing a laminate package comprising providing a semiconductor integrated circuit (IC) electrically connected to a substrate in a flip-chip ball grid array configuration. Providing a laminate package lid comprising a top portion, an outer wall, and a protruding member, the outer wall perpendicular to the top portion; and the protruding member extending from the top portion. The method of manufacturing further comprising attaching the outer wall of the laminate package lid to an outer portion of the substrate by a first adhesive substance, wherein the top portion of the laminate package covers the semiconductor IC and wherein the top portion of the laminate package is in thermal contact with the semiconductor IC; and attaching the protruding member to the substrate between the semiconductor IC and the outer wall by a non-conductive adhesive substance.

An example electrical system electrical system is further provided. The example electrical system, comprising a printed circuit board (PCB) and a laminate package. The PCB comprising one or more electrical contact pads. The laminate package comprising: a semiconductor IC electrically connected to a substrate in a flip-chip ball grid array configuration, a laminate package lid and one or more conductive balls electrically connecting the semiconductor IC to the one or more electrical contact pads of the PCB. The laminate package lid comprising: a top portion covering the semiconductor IC, wherein the top portion of the laminate package lid is in thermal contact with the semiconductor IC; an outer wall perpendicular to the top portion, wherein the outer wall is attached to an outer portion of the substrate by a first adhesive substance; and a protruding member extending from the top portion and attaching to the substrate between the semiconductor IC and the outer wall by a non-conductive adhesive substance.

In some embodiments, a cross-section of the protruding member at an interface with the substrate comprises at least one dimension greater than one millimeter.

In some embodiments, the cross-section of the protruding member at the interface with the substrate is a rectangle having a first dimension and a second dimension.

In some embodiments, the protruding member further comprising a protruding member height measured from a bottom surface of the top portion of the laminate package lid, wherein the protruding member height is between 0.2 millimeters and 0.3 millimeters.

In some embodiments, a first distance between the protruding member and the semiconductor IC is less than a second distance between the protruding member and the outer wall.

In some embodiments, the first distance is between 1 millimeter and 2 millimeters.

In some embodiments, the laminate package lid further comprising a second protruding member positioned opposite the semiconductor IC of the protruding member.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 depicts a cross-section view of an example laminate package.
FIG. 2 illustrates a cross-section view of an example laminate package experiencing delamination between the laminate package lid, the thermal interface material, and the semiconductor IC.
FIG. 3 illustrates a cross-section view of an example laminate package lid in accordance with an example embodiment of the present disclosure.
FIG. 4 illustrates a bottom view of an example laminate package lid in accordance with an example embodiment of the present disclosure.
FIG. 5 illustrates a top view of an example laminate package substrate for receiving a laminate package lid in accordance with an example embodiment of the present disclosure.
FIG. 6 illustrates a cross-section view of an example laminate package comprising a laminate package lid in accordance with an example embodiment of the present disclosure.
FIG. 7 depicts an example flowchart depicting a method for manufacturing an example laminate package in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with delamination between a semiconductor IC, a laminate package lid, and the thermal interface material positioned between the semiconductor IC and the laminate package lid of a laminate package. As understood by those of skill in the field to which the present disclosure pertains, delamination of the thermal interface material between the semiconductor IC and the laminate package lid may cause various issues related to the reliability and performance of a semiconductor IC in a laminate package. As such, great benefit may be realized by preventing the degradation of the interface between the semiconductor IC, the thermal interface material, and the laminate package lid of a laminate package.

In general, many electronic systems utilize printed circuit boards (PCBs) to support and connect the various electrical components of the electrical system. A PCB may include a rigid structure with a plurality of mount regions configured to receive various electrical components. The PCB may further include conductive traces or paths to enable electrical connections between the various electrical components. A PCB may commonly receive surface-mounted and/or socketed electrical components, including various semiconductor ICs.

One example structure for connecting a semiconductor IC to a PCB is a laminate package. A laminate package is a surface-mount technology providing structural support for a semiconductor IC. In addition, a laminate package may provide protection from certain environmental factors in a surrounding environment. The laminate package includes conductive surfaces (e.g., leads or conductive balls) to provide an electrical connection between the PCB and the semiconductor IC without through holes. The conductive surfaces are positioned on the bottom of the laminate package and are positioned to be electrically coupled with conductive pads on the surface of the PCB. The laminate package protects the electrical components and electrical connections of the semiconductor IC from environmental factors from the surrounding environment, ensuring reliability of the electrical system even in extreme conditions.

One example structure for connecting a semiconductor IC to a PCB is a flip chip ball grid array (FCBGA) package. A FCBGA package differs from other surface-mount packages in that the semiconductor IC (e.g., die) is flipped such that the electrical contact points of the semiconductor IC are facing the substrate surface of the laminate package. The FCBGA package architecture may be more reliable than other surface-mounted packages, particularly at high frequencies. The FCBGA package may additionally be more robust in harsh environments.

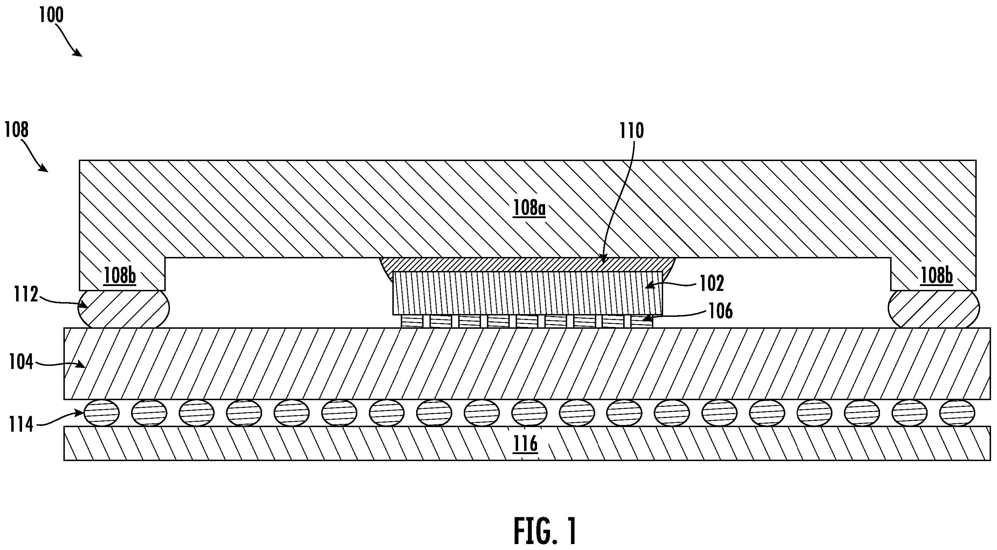

Referring now to FIG. 1, an example FCBGA laminate package 100 is provided. The example FCBGA laminate package 100 includes a semiconductor IC 102 electrically connected to a substrate 104 by one or more conductive interconnects 106. The example FCBGA laminate package 100 further includes a laminate package lid 108 comprising a top portion 108a and an outer wall 108b. The top portion 108a of the laminate package lid 108 covers the semiconductor IC 102 and is in thermal contact with the semiconductor IC 102 via a thermal interface material 110. The outer wall 108b of the laminate package lid 108 is attached to the substrate 104 by an adhesive 112. As further depicted in FIG. 1, the FCBGA laminate package 100 is electrically connected to a PCB 116 by a plurality of conductive balls 114.

A laminate package is any structure for providing an electrical connection to a semiconductor IC 102 without the use of through-holes or exposed wire bonds. A laminate package provides a surface-mount and/or socket mount for a semiconductor IC 102 contained within the laminate package to an electrical system (e.g., a PCB 116). An FCBGA laminate package 100 is a type of laminate package in which the semiconductor IC 102 is flipped, such that the conductive interconnects 106 (typically on the top surface of the semiconductor IC 102) are adjacent to the substrate 104. Certain advantages may be realized from an FCBGA laminate package 100, such as increased reliability, particularly in high frequency and/or harsh environments. An FCBGA laminate package 100 provides structural support to a semiconductor IC 102 and the conductive interconnects 106. The FCBGA laminate package 100 protects the electrical components, including the semiconductor IC 102, from the environmental factors of a surrounding environment, such as wind, rain, dirt, liquids, extreme temperatures, and so on.

As depicted in FIG. 1, the FCBGA laminate package 100 is configured to protect a semiconductor IC 102 as well as provide an electrical connection between the semiconductor IC 102 and the PCB 116. A semiconductor IC 102 (e.g., semiconductor die) is any block of semiconductor material utilizing circuitry and/or electrical components to perform one or more functions. A semiconductor IC 102 may include a processor, reconfigurable fabric, passive electrical components, active electrical components, memory, communications circuitry, and/or any other electrical components necessary to perform the functionality of the semiconductor IC 102.

A semiconductor IC 102 is further configured to receive and/or generate one or more electrical signals. The one or more electrical signals are transmitted between the semiconductor IC 102 and the PCB 116 through the one or more conductive interconnects 106. The one or more conductive interconnects 106 positioned on the surface of the semiconductor IC 102 are electrically connected to the plurality of conductive balls 114 via conductive traces through the substrate 104.

As further depicted in FIG. 1, the FCBGA laminate package 100 is electrically connected to the PCB 116 by the plurality of conductive balls 114. A PCB 116 is a structure comprising laminated layers of conductive and insulating material, providing rigid structure and electrical connections between various electrical components (e.g., laminate packages) of an electrical system. A PCB 116 may utilize copper or a similar conductor to form electrical paths between the electrical components comprising the electrical system. The conductive layers may be accompanied by one or more insulating layers. Insulating layers may be comprised of an insulating material, such as fiberglass. A PCB 116 may enable the integration of one or more electrical components by surface mount technologies. Surface mount technologies provide for attaching electrical components directly to the surface of the PCB 116. Surface mount technologies enable increased automation in the manufacture of electrical systems utilizing a PCB 116. In addition, surface mount technologies reduce cost and improve the quality and reliability of the electrical system.

A PCB 116 may include a plurality of conductive pads configured to interface with the conductive balls 114 of an FCBGA laminate package 100. A conductive pad is any conductive portion on a surface of the PCB 116 configured to provide an electrical connection to one or more electrical paths in or on the PCB 116. The conductive pads may be configured to align with the conductive balls 114 of an FCBGA laminate package 100. A conductive bond such as solder, may be utilized to attach the conductive balls 114 of the FCBGA laminate package 100 to the conductive pads of the PCB 116.

As further depicted in FIG. 1, the FCBGA laminate package 100 includes a laminate package lid 108. The laminate package lid 108 comprises any thermally conductive material having a top portion 108a and an outer wall 108b and designed to attach to a surface of the substrate 104 to partially or fully enclose the semiconductor IC 102. The outer wall 108b of the laminate package lid 108 is attached to the surface of the substrate 104 with an adhesive 112. The laminate package lid 108 provides protection to the semiconductor IC 102 from various environmental factors of a surrounding environment, such as wind, rain, dirt, liquids, extreme temperatures, and so on.

In addition, the laminate package lid 108 is configured to receive and dissipate heat from the semiconductor IC 102. Semiconductor ICs 102 in an FCBGA laminate package 100 generate heat during operation. Too much heat at a semiconductor IC 102 during operation can damage the semiconductor IC 102 and/or other electrical components. Thus, the laminate package lid 108 may comprise a thermally conductive material designed to receive heat from the semiconductor IC 102 and dissipate the heat into an external environment. For example, in some embodiments, the laminate package lid 108 may comprise a metallic material.

To more efficiently dissipate heat from the semiconductor IC 102 a thermally conductive path is formed between the semiconductor IC 102 and the laminate package lid 108 by a thermal interface material 110. A thermal interface material 110 is any material positioned between the semiconductor IC 102 and the laminate package lid 108 to enhance the thermal coupling between the two components. In some embodiments, the thermal interface material 110 may be flexible and/or malleable. A flexible thermal interface material 110 may enable movement between the semiconductor IC 102 and the malleable package lid 108 while still maintaining thermal coupling. However, in some instances, especially in harsh environments, changes in temperature, humidity, motion, and/or other environmental factors may crack the thermal interface material 110 and/or separate the thermal interface material 110 from the semiconductor IC 102 and/or the laminate package lid 108. In addition, gaps may form in the thermal interface material 110. Gaps in the thermal interface material 110 may reduce the thermal coupling of the semiconductor IC 102 to the laminate package lid 108. Separation of the thermal interface material 110 from the laminate package lid 108 and/or from the semiconductor IC 102 and gaps in the thermal interface material 110 may be referred to as delamination.

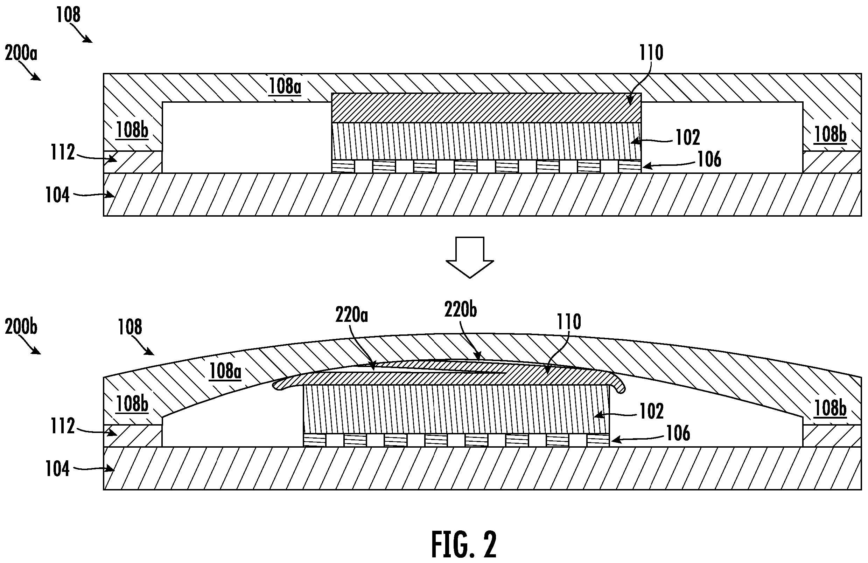

Referring now to FIG. 2, an example of delamination (e.g., gaps 220a, 220b) at the interface between the top portion 108a of the laminate package lid 108 and the semiconductor IC 102 is shown. As depicted in FIG. 2, the FCBGA laminate package 200a includes a laminate package lid 108 having a top portion 108a and an outer wall 108b attached to a surface of the substrate 104 with an adhesive 112. The FCBGA laminate package 200a further includes a semiconductor IC 102 electrically connected to one or more conductive interconnects 106. A thermal interface material 110 is positioned between the semiconductor IC 102 and the top portion 108a of the laminate package lid 108 creating a thermal coupling between the semiconductor IC 102 and the laminate package lid 108.

During operation, a laminate package may be exposed to different environmental factors, such as water, humidity, extreme temperatures, oil, dirt, and so on. Changes in environmental factors may cause expansion, contraction, and/or movement of the components of the FCBGA laminate package 100. For example, as depicted in FIG. 2, the laminate package lid 108 of the FCBGA laminate package 200b is deformed. Such deformation may be caused by changes in the environmental factors of the environment surrounding the FCBGA laminate package 100. In addition, similar deformations may occur throughout the operational life of a FCBGA laminate package 100.

As further depicted in FIG. 2, deformations may lead to delamination (e.g., gaps 220a, 220b) of the thermal interface material 110. Delamination occurs when gaps (e.g., gap 220a, gap 220b) form in the thermal interface material 110 thermally coupling the semiconductor IC 102 to the laminate package lid 108. Delamination may occur between the thermal interface material 110 and a surface of the semiconductor IC 102 and/or between the thermal interface material 110 and a surface of the laminate package lid 108 (e.g., gap 220b). Delamination may also occur within the thermal interface material 110 (e.g., gap 220a). Delamination may reduce the efficiency of the thermal coupling between the semiconductor IC 102 and the laminate package lid 108, reducing the dissipation of heat from the semiconductor IC 102. Failure to dissipate heat at or near the semiconductor IC 102 may lead to inefficient operation and/or failure of the semiconductor IC 102.

The various example embodiments described herein utilize one or more protruding members extending from a top portion of a laminate package lid and attaching to a surface of a substrate by a non-conductive adhesive substance between the semiconductor IC and an outer wall to prevent delamination. The one or more protruding members enable the top portion of the laminate package lid to remain in contact with the semiconductor IC and the thermal interface materials, even in an instance in which the components of the FCBGA laminate package expand and contract. The one or more protruding members further prevent gaps from forming within the thermal interface material of the FCBGA laminate package.

In some embodiments, a first distance between the protruding member and the semiconductor IC is less than a second distance between the protruding member and the outer wall. In some embodiments, a plurality of protruding members attach to the substrate on opposite sides of the semiconductor IC providing further structural elements preventing separation between the laminate package lid and the semiconductor IC. Further, in some embodiments, at least one dimension of the cross-section of the protruding member interfacing with the substrate is greater than one millimeter. A cross-section dimension greater than one millimeter ensures sufficient surface area to adhere the protruding member to the substrate even when exposed to changes in the environmental factors of an external environment.

As a result of the herein described example embodiments, the reliability of FCBGA laminate packages housing one or more semiconductor ICs may be greatly improved. In addition, FCBGA laminate packages comprising laminate package lids in accordance with the present disclosure may perform more efficiently, even when exposed to changing environment conditions and/or when operated for long durations.

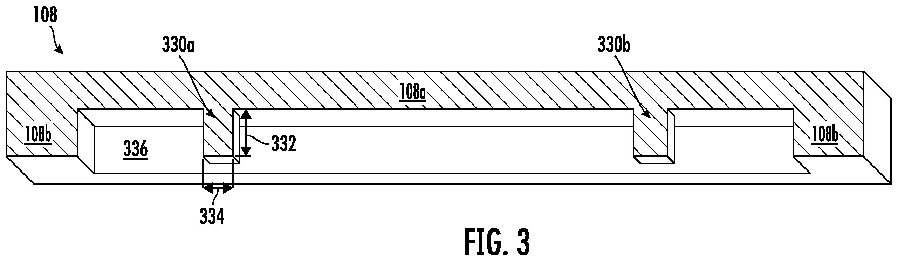

Referring now to FIG. 3, a cross-section of an example laminate package lid 108 is provided. As depicted in FIG. 3, the example laminate package lid 108 includes a top portion 108a and an outer wall 108b extending from the outer portion of the laminate package lid 108 perpendicular to the top portion 108a. As further depicted in FIG. 3, the laminate package lid comprises a first protruding member 330a and a second protruding member 330b extending from a bottom surface 336 of the top portion 108a of the laminate package lid 108. Each protruding member 330a, 330b is associated with a protruding member width 334 and a protruding member height 332.

As depicted in FIG. 3, the example laminate package lid 108 includes an outer wall 108b. The outer wall 108b forms the outer perimeter of the laminate package lid 108. The outer wall 108b extends from the top portion 108a of the laminate package lid 108 at or near the periphery of the top portion 108a. In some embodiments, the outer wall 108b may completely enclose a semiconductor IC within the FCBGA laminate package. In some embodiments, the outer wall 108b may be configured to align with the outer perimeter of an underlying substrate (e.g., substrate 104 as shown in FIG. 1 and FIG. 2).

As further depicted in FIG. 3, the laminate package lid 108 includes a plurality of protruding members 330a, 330b. The protruding members 330a, 330b extended from the bottom surface 336 of the top portion 108a of the laminate package lid 108 within the space enclosed by the outer wall 108b. Although depicted as perpendicular to the top portion 108a and parallel to the outer wall, 108b, the protruding members 330a, 330b may extend from the bottom surface 336 of the top portion 108a of the laminate package lid 108 at any angle. The protruding members 330a, 330b are each associated with a protruding member height 332 and a protruding member width 334. The protruding member height 332 is measured from the bottom surface 336 of the top portion 108a of the laminate package lid 108 to the furthest extent of the distal end of the protruding member 330a, 330b. The protruding member height 332 may be dependent on the size of the FCBGA laminate package, including the dimensions of the semiconductor IC, the conductive interconnects, and the thermal interface material. In some embodiments, the protruding member height may be between 0.2 millimeters and 1 millimeter; more preferably between 0.2 millimeters and 0.7 millimeters; most preferably between 0.2 millimeters and 0.3 millimeters. The protruding members 330a, 330b may provide sufficient structure to limit any deformation of the laminate package lid 108 at or near a semiconductor IC, preventing delamination of the thermal interface material.

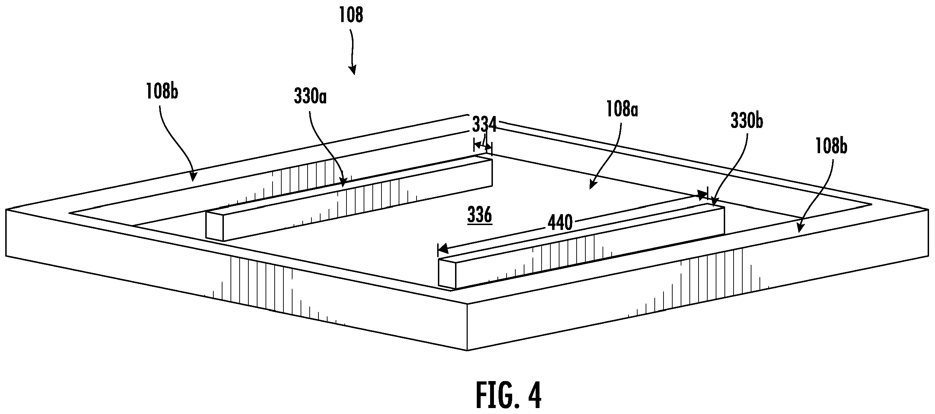

Referring now to FIG. 4, a bottom view of an example laminate package lid 108 is provided. As depicted in FIG. 4, the example laminate package lid 108 includes a top portion 108a and an outer wall 108b extending from the bottom surface 336 of the top portion 108a of the laminate package lid 108. As further depicted in FIG. 4, the laminate package lid 108 comprises a first protruding member 330a and a second protruding member 330b, each extending from the bottom surface 336 of the top portion 108a of the laminate package lid 108. The protruding members 330a, 330b are each associated with a protruding member width 334 and a protruding member depth 440.

The cross-section of the protruding members 330a, 330b, as shown in FIG. 4, represents the surface interfacing with the substrate of the FCBGA laminate package. As shown in FIG. 4, the protruding members 330a, 330b have a rectangular cross-section with a first dimension (e.g., protruding member depth 440) greater than a second dimension (e.g., protruding member width 334). However, the cross-section of the protruding members 330a, 330b may comprise any shape with a sufficient surface area to attach to an underlying substrate by a non-conductive adhesive.

In some embodiments, at least one dimension of the cross-section of the protruding members 330a, 330b is greater than 1 millimeter. A laminate package lid 108 comprising protruding members 330a, 330b having a cross-section of greater than 1 millimeter at the interface with the underlying substrate ensures enough surface area to securely attach the protruding members 330a, 330b to the substrate.

Although two protruding members 330a, 330b are depicted in FIG. 4, in some embodiments, three or more disjoint protruding members may extend from the bottom surface 336 of the top portion 108a of the laminate package lid 108. For example, in some embodiments, four protruding members 330a, 330b may extend from the bottom surface 336 of the top portion 108a of the laminate package lid 108. For instance, four protruding members 330a, 330b forming a disjoint rectangle around a semiconductor IC.

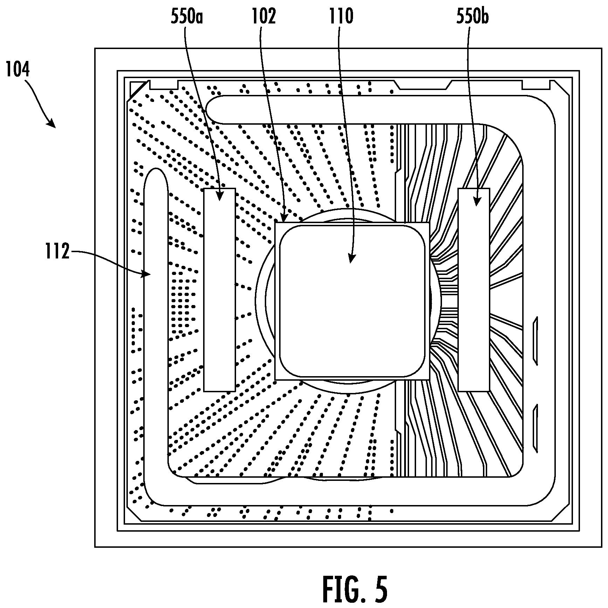

Referring now to FIG. 5, an example substrate 104 configured to receive a laminate package lid 108 in accordance with one or more embodiments of the present invention is provided. As depicted in FIG. 5, the example substrate 104 comprises a semiconductor IC 102 having a thermal interface material 110 disposed on the top surface. An adhesive 112 is disposed on the outer portion of the substrate 104 and configured to align with an outer wall of a laminate package lid 108. A non-conductive adhesive 550a, 550b is additionally disposed on the surface of the substrate 104 and configured to align with a plurality of protruding members extending from a laminate package lid.

As depicted in FIG. 5, a non-conductive adhesive 550a, 550b is disposed on the surface of the substrate 104. A non-conductive adhesive 550a, 550b comprises any adhesive substance configured to adhere to the surface of the substrate 104 and the one or more protruding members, securely attaching a laminate package lid to the surface of the substrate 104. A non-conductive adhesive 550a, 550b may comprise a glue, epoxy, insulation adhesive, or similar adhesive. A non-conductive adhesive 550a, 550b region is positioned on the surface of the substrate 104 to align with each protruding member of the laminate package lid 108. For example, in an instance in which a laminate package lid comprises four protruding members, four non-conductive adhesive regions are disposed on the surface of the substrate 104.

As further depicted in FIG. 5, an adhesive 112 is disposed on an outer portion of the substrate 104. The adhesive 112 comprises any adhesive substance configured to adhere to the surface of the substrate 104 and the outer wall of the laminate package lid, securely attaching the laminate package lid to the surface of the substrate 104. An adhesive 112 may comprise a glue, epoxy, or similar adhesive. An adhesive 112 region is positioned on an outer portion of the surface of the substrate 104 to align with the outer wall of the laminate package lid. In some embodiments, the adhesive 112 is the same substance as the non-conductive adhesive 550a, 550b used to attach the protruding members of the laminate package lid to the surface of the substrate 104.

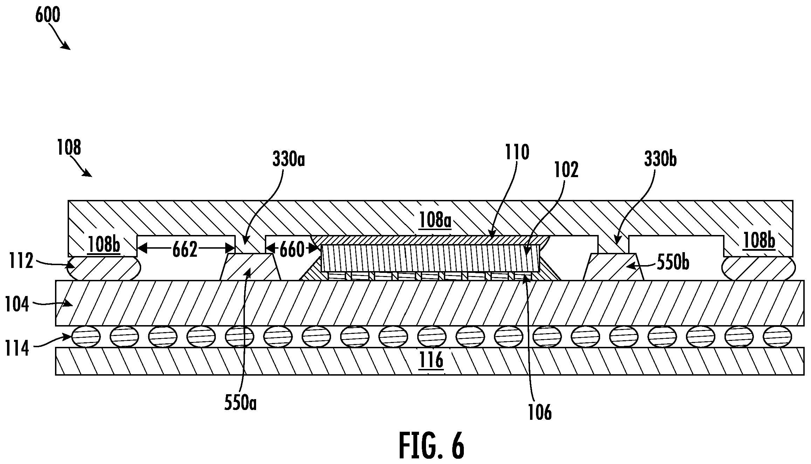

Referring now to FIG. 6, an example FCBGA laminate package 600 is provided. As depicted in FIG. 6, the example FCBGA laminate package 600 includes a semiconductor IC 102 electrically connected to a substrate 104 by one or more conductive interconnects 106. The example FCBGA laminate package 600 further includes a laminate package lid 108 comprising a top portion 108a, an outer wall 108b, and a plurality of protruding members 330a, 330b. The top portion 108a of the laminate package lid 108 covers the semiconductor IC 102 and is in thermal contact with the semiconductor IC via a thermal interface material 110. The outer wall 108b of the laminate package lid 108 is attached to the substrate by an adhesive 112, and the plurality of protruding members 330a, 330b are attached to the substrate 104 by a non-conductive adhesive 550a, 550b. As further depicted in FIG. 6, the FCBGA laminate package 600 is electrically connected to a PCB 116 by a plurality of conductive balls 114.

As further depicted in FIG. 6, each of the protruding members 330a, 330b are positioned between the outer wall 108b and the semiconductor IC 102 such that a first distance 660 is defined between the protruding member 330a, 330b and the semiconductor IC 102 and a second distance 662 is defined between the protruding member 330a, 330b and the outer wall 108b directly opposite the protruding member 330a, 330b from the semiconductor IC 102. In some embodiments, the first distance 660 between the protruding member 330a, 330b and the semiconductor IC 102 is less than the second distance 662 between the protruding member 330a, 330b and the outer wall 108b. In other words, the protruding member 330a, 330b is positioned closer to the semiconductor IC 102 than the outer wall 108b. Positioning the protruding member 330a, 330b closer to the semiconductor IC 102 limits the movement of the laminate package lid 108 relative to the semiconductor IC 102 compared to positioning the protruding member 330a, 330b farther from the semiconductor IC 102. Limiting the movement of the laminate package lid 108 helps eliminate delamination of the thermal interface material 110 due to stresses.

In some embodiments, the first distance 660 between the protruding member 330a, 330b and the semiconductor IC 102 is between 0.2 millimeters and 3 millimeters; more preferably between 0.5 millimeters and 2.5 millimeters; most preferably between 1 millimeters and 2 millimeters. By comparison, in some embodiments, the protruding member depth 440 is greater than the first distance 660.

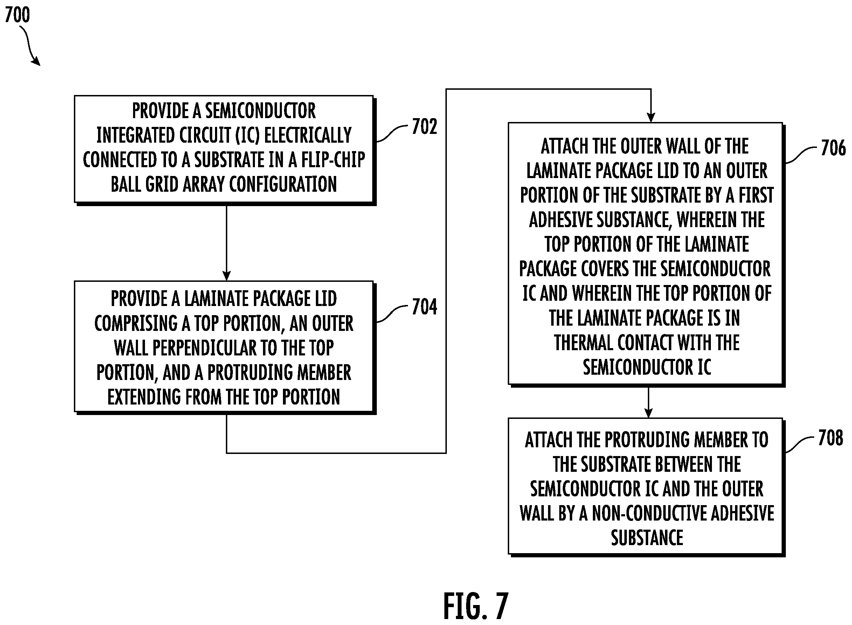

Referring now to FIG. 7, a flowchart depicting an example method 700 for manufacturing a FCBGA laminate package (e.g., FCBGA laminate package 600). At block 702, a semiconductor IC (e.g., semiconductor IC 102) electrically connected to a substrate (e.g., substrate 104) in a flip-chip ball grid array configuration is provided. In a flip-chip ball grid array configuration, the semiconductor IC is positioned such that the surface comprising the conductive contact points interfaces with the conductive interconnects (e.g., conductive interconnects 106) of the substrate. Thus, the bottom surface of the semiconductor IC is configured to interface with the laminate package lid (e.g., laminate package lid 108).

At block 704, a laminate package lid (e.g., a laminate package lid as depicted in FIG. 3, FIG. 4, FIG. 6) comprising a top portion (e.g., top portion 108a), an outer wall (e.g., outer wall 108b) perpendicular to the top portion, and a protruding member (e.g., protruding member 330a, 330b) extending from the top portion is provided. In some embodiments, the laminate package lid may comprise a metal or other thermally conductive material. In some embodiments, the material comprising the protruding members may comprise a different material than the material comprising the top portion and outer wall.

At block 706, the outer wall of the laminate package lid is attached to an outer portion of the substrate by a first adhesive substance, wherein the top portion of the laminate package covers the semiconductor IC and wherein the top portion of the laminate package is in thermal contact with the semiconductor IC. The laminate package lid may provide protection from environmental factors such as wind, rain, dirt, liquids, extreme temperatures, and so on. In addition, the laminate 'package lid may facilitate dissipation of heat from the semiconductor IC to an external environment through thermal interface material.

At block 708, the protruding member is attached to the substrate between the semiconductor IC and the outer wall by a non-conductive adhesive substance. As described herein, the protruding member may be positioned closer to the semiconductor IC than to the outer wall. Positioning the protruding member closer to the semiconductor IC further limits the delamination of the thermal interface material due to stress.

While this detailed description has set forth some embodiments of the present invention, the appended claims cover other embodiments of the present invention which differ from the described embodiments according to various modifications and improvements. For example, one skilled in the art may recognize that such principles may be applied to any electronic device that utilizes a laminate package in a FCBGA configuration.

Within the appended claims, unless the specific term "means for" or "step for" is used within a given claim, it is not intended that the claim be interpreted under 35 U.S.C. 112, paragraph 6.

Use of broader terms such as "comprises," "includes," and "having" should be understood to provide support for narrower terms such as "consisting of," "consisting essentially of," and "comprised substantially of" Use of the terms "optionally," "may," 2 "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A laminate package (100) comprising:
a semiconductor integrated circuit, IC, (102) electrically connected to a substrate (104) in a flip-chip ball grid array configuration; and
a laminate package lid (108) comprising:
a top portion (108a) covering the semiconductor IC, wherein the top portion of the laminate package lid is in thermal contact with the semiconductor IC;
an outer wall (1089b) perpendicular to the top portion, wherein the outer wall is attached to an outer portion of the substrate by a first adhesive substance; and
a protruding member (330a) extending from the top portion and attaching to the substrate between the semiconductor IC and the outer wall by a non-conductive adhesive substance.

2. The laminate package of claim 1, wherein a cross-section of the protruding member at an interface with the substrate comprises at least one dimension greater than one millimeter.

3. The laminate package of claim 2, wherein the cross-section of the protruding member at the interface with the substrate is a rectangle having a first dimension and a second dimension.

4. The laminate package of claim 3, the protruding member further comprising a protruding member height measured from a bottom surface of the top portion of the laminate package lid, wherein the protruding member height is between 0.2 millimeters and 0.3 millimeters.

5. The laminate package of claim 1, wherein a first distance between the protruding member and the semiconductor IC is less than a second distance between the protruding member and the outer wall.

6. The laminate package of claim 5, wherein the first distance is between 1 millimeter and 2 millimeters.

7. The laminate package of claim 1, the laminate package lid further comprising a second protruding member (330b) positioned opposite the semiconductor IC from the protruding member.

8. The laminate package of claim 1, the laminate package lid further comprising a plurality of protruding members, wherein each protruding member of the plurality of protruding members is positioned on a different side of the semiconductor IC.

9. The laminate package of claim 1, wherein the first adhesive substance and the non-conductive adhesive substance comprise the same substance.

10. The laminate package of claim 1, further comprising thermal interface materials positioned between the laminate package lid and the semiconductor IC.

11. The laminate package of claim 10, wherein the thermal interface materials provide a thermally conductive path between the semiconductor IC and the laminate package lid.

12. The laminate package of claim 1, wherein the laminate package lid comprises a metal material.

13. A method of manufacturing a laminate package, comprising:
Providing (702) a semiconductor integrated circuit (IC) electrically connected to a substrate in a flip-chip ball grid array configuration;
Providing (704) a laminate package lid comprising:
a top portion;
an outer wall perpendicular to the top portion; and
a protruding member extending from the top portion;
attaching (706) the outer wall of the laminate package lid to an outer portion of the substrate by a first adhesive substance, wherein the top portion of the laminate package covers the semiconductor IC and wherein the top portion of the laminate package is in thermal contact with the semiconductor IC; and
attaching (708) the protruding member to the substrate between the semiconductor IC and the outer wall by a non-conductive adhesive substance.

14. An electrical system, comprising:
a printed circuit board, PCB, (116) comprising one or more electrical contact pads;
a laminate package according to any one of claims 1 to 7; and
one or more conductive balls (114) electrically connecting the semiconductor IC to the one or more electrical contact pads of the PCB.
